# EUROPEAN PATENT APPLICATION

(11) **EP 4 793 223 A1**
(43) Date of publication of application: **19.08.2026**
(21) Application number: 25158191.4
(22) Date of filing: 17.02.2025
(51) Int. Cl.: B81B 7/00, B81C 1/00

(54) **ASIC CAPPED DOUBLE LAYER MEMS PLATFORM**

(71) Applicant: Murata Manufacturing Co., Ltd., Nagaokakyo-shi, Kyoto 617-8555 (JP)
(72) Inventor: KILPINEN, Petteri, 02620 Espoo (FI)
(74) Representative: Boco IP Oy Ab

(57) **Abstract**

The disclosure relates to a microelectromechanical (MEMS) device and to a method of manufacturing a MEMS device. The MEMS device comprises a a cap layer, two MEMS device layers and an ASIC layer, while the cap layer and the ASIC layer enclose functional elements of the two MEMS device layers in an enclosure. Digital signals, ground and operating voltage of ASIC circuitry are coupled with outside of the MEMS device through one or more ASIC signal through-silicon-vias traveling through the two MEMS device layers and the cap layer.

## Description

### FIELD OF THE DISCLOSURE

The present invention relates to MEMS devices and to a method of producing MEMS devices. More particularly, the present invention relates to MEMS devices comprising an ASIC layer, two MEMS device layers, and a gap layer and to a method for manufacturing MEMS devices comprising an ASIC layer, a gap layer and two MEMS device layers.

### BACKGROUND OF THE DISCLOSURE

Microelectromechanical systems (MEMS) devices manufactured using silicon-based technology are widespread. Typical application of MEMS device is an inertial sensor that detects at least one of acceleration and angular velocity. MEMS devices of this type are widely used in consumer, automotive and industrial applications.

Capacitive sensing in MEMS devices is implemented by detecting change of capacitance caused by change in distance between two electrodes. Typically, capacitance is sensed between a moveable electrode and one or more fixed electrodes.

In typical capacitive MEMS devices for inertial sensing, fixed electrodes are provided on a substrate, such as a handle wafer or a cap wafer. For example, a metal electrode may be provided on a surface of the substrate wafer. The MEMS device is subject to various sources of stress. During packaging of components, some steps of the process such as moulding applies pressure on the substrate. Different materials have different thermal characteristics and therefore the substrate may also be subject to pressure due to differences in thermal expansion of materials within the MEMS device package. The MEMS device may also be subject to various external forces causing changes in the shape of the substrate. Environment in which the MEMS device is used may be subject to great temperature changes, vibration, impacts and so on, all causing stress on the MEMS device. When fixed electrodes are attached to the substrate, any change in form of the substrate caused by stress may also affect distance between the fixed electrodes and respective moveable electrodes. This causes risk of deterioration of accuracy of capacitive sensing.

In the following description, reference will be made to an inertial MEMS sensor and to the problems for the manufacturing thereof. However, the present disclosure generally applies to other types of MEMS devices. For example, the MEMS device may comprise one or more of the following structures, single or combined with each other: accelerometer, gyroscope, geophone, inclinometer and resonator. Furthermore, the MEMS device may be a MEMS actuator.

According to some embodiments the MEMS device is an accelerometer, a gyroscope or a combination thereof.

According to some embodiments, the MEMS device is both a gyroscope and an accelerometer. According to some embodiments, the same moveable mass element may be used as both the acceleration-sensitive element in the MEMS device, and as an element whose oscillation is altered by the Coriolis force when the device undergoes angular rotation to implement a gyroscope. According to some embodiments, different moveable elements are used for sensing acceleration and angular rotation.

In the following drawings, features of the invented MEMS device are illustrated with help of cross-sections of parts of wafers/layers forming the MEMS device or as cross-sections of the MEMS device itself. It is preferable to perform manufacturing steps in wafer form, so that a plurality of MEMS devices is manufactured at the same time, and the readily manufactured and preferably also tested and/or calibrated MEMS devices are separated from each other only at the very end of the manufacturing process. Handling of wafers is easier than handling of individual devices, which gives significant benefits through reduced complexity and thus cost savings. In this context, the term layer refers both to a layer of a wafer before dicing and to a layer of a MEMS device after dicing.

In some known MEMS devices silicon vias in a cap layer are used for bringing MEMS signals from a MEMS device layer to a top side of the cap layer of a MEMS chip. Bond pads are provided on the top side of the cap layer that encloses functional parts of the MEMS device into an enclosure. Bond pads are also provided on top side of an application specific integrated circuit (ASIC) chip, which is also referred herein as an ASIC layer. In the assembly phase, a small MEMS chip is placed on top of the ASIC chip, or the MEMS chip and the ASIC chip are arranged side-to-side, and MEMS signals are electrically coupled to the ASIC chip by wire bonding. A problem with such structures is that wire bonding is error prone and adds manufacturing costs of the MEMS device. Wire bonding may also cause various signal quality challenges to sensitive MEMS signals carried between the MEMS chip and the ASIC chip. Wire bonding also sets constraints in the manufacturing process. For example, there are constraints for thickness of ASIC wafers/layers/chips and/or thickness of MEMS layers/wafers/chips that are to be wire bonded.

### DESCRIPTION OF THE RELATED ART

Patent application EP4421022 A1 discloses double layer MEMS devices with two functional MEMS device layers made of single-crystal silicon.

Patent application US 2016/0152466 A1 discloses a MEMS sensor device in which a rewiring element and an ASIC substrate are used for capping micromechanical functional layers.

Patent application EP 4425189 A1 discloses a capacitive MEMS device with two MEMS device layers directly bonded to each other at selected parts.

Patent application EP 3705451 A1 illustrates a MEMS device including a cap with a via.

### BRIEF DESCRIPTION OF THE DISCLOSURE

An object of the present disclosure is to provide a MEMS device and a method to manufacture a MEMS device so as to solve the above problems.

The object of the disclosure is achieved by a MEMS device which are characterized by what is stated in the independent claims. Some embodiments of the disclosure are disclosed in the dependent claims.

The disclosure is based on the idea of capping the MEMS device layers with an ASIC layer. A standard CMOS ASIC wafer is bonded on a double-layered CSOI platform structure and a cap wafer comprising vias. The passive cap layer is used as the bottom layer of the MEMS device. Digital signals, ground and operating voltage(s) are carried between the ASIC layer and outside of the MEMS device through ASIC signal through-silicon-vias, in short AS-TSVs, extending through the MEMS device layers and the cap layer.

According to an aspect, a microelectromechanical system, MEMS, device is provided. The MEMS device comprises a cap layer comprising metallic patterns on a first face of the cap layer, first metal pads on a second face of the cap layer, and silicon vias electrically coupling at least part of the metallic patterns and the first metal pads.

The MEMS device comprises a second MEMS device layer comprising functional elements of the MEMS device. Parts of the second MEMS device layer are electrically coupled to the respective metallic patterns on the first face of the cap layer.

The MEMS device comprises a first MEMS device layer comprising further functional elements of the MEMS device. Parts of the first MEMS device layer are electrically coupled to respective parts of the second MEMS device layer.

The MEMS device comprises an ASIC layer comprising a metal stack and a substrate layer. The outer face of the metal stack forms a first face of the ASIC layer. The outer face of the substrate layer forms a second face of the ASIC layer. The substrate layer comprises ASIC circuitry. The first face of the ASIC layer comprises a plurality of second metal pads electrically coupled via the metal stack to a plurality of signal interfaces of ASIC circuitry. The plurality of second metal pads is electrically coupled to parts of the first MEMS device layer.

Mutually electrically coupled parts of the first MEMS device layer, the second MEMS device layer, and the cap layer form at least one ASIC signal through-silicon-via, AS-TSV. The AS-TSV is configured to electrically couple a digital signal, ground or operating voltage of the ASIC circuitry via electrical contacts provided by one of the second metal pads on the first face of the ASIC layer to the respective first metal pad on the second face of the cap layer.

According to some embodiments, the second MEMS device layer comprises at least one first electrode. Mutually electrically coupled parts of the first MEMS device layer and the second MEMS device layer form a first MEMS through silicon via, MEMS-TSV. The MEMS-TSV electrically couples a respective one of the at least one first electrode to a respective second metal pad coupled to a respective signal interface of the ASIC circuitry.

According to some embodiments the metallic patterns on the first face of the cap layer further comprise at least one static electrode. Mutually electrically coupled parts of the first MEMS device layer and the second MEMS device layer form a second MEMS-TSV. The second MEMS-TSV electrically couples a respective one of the at least one static electrode to a respective second metal pad coupled to a respective signal interface of the ASIC circuitry.

According to some embodiments, parts of the first MEMS device layer are directly electrically coupled with the second MEMS device layer by means of anodic bonding.

According to some embodiments, the cap layer is electrically coupled with the second MEMS device layer by means of direct bonding.

According to some embodiments, the plurality of second metal pads of the ASIC layer is electrically coupled to parts of the first MEMS device layer by means of any one of glass frit bonding, adhesive bonding, anodic bonding, eutectic metal bonding, metal to metal bonding and direct bonding.

According to some embodiments, the MEMS device further comprises a test-through-silicon-via, test-TSV. The test-TSV is configured to couple a signal to or from any one of the ASIC circuitry, the first MEMS device layer, the second MEMS device layer to a first metal pad for enabling testing and/or calibration of the MEMS device.

According to another aspect, a method for manufacturing a microelectromechanical system, MEMS, device is provided. The method comprises i) providing a cap layer comprising metallic patterns arranged on a first face of the cap layer, ii) providing a MEMS device platform comprising handle layer, a buried silicon dioxide layer, a first MEMS device layer and a second MEMS device layer. The buried silicon dioxide layer is between the handle layer and the first MEMS device layer. The first MEMS device layer and the second MEMS device layer comprise functional elements of the MEMS device platform. Parts of the first MEMS device layer are electrically coupled to respective parts of the second MEMS device layer.

The method further comprises iii) providing an ASIC layer. The ASIC layer comprises a substrate layer comprising ASIC circuitry and a metal stack. A first face of the ASIC layer on the metal stack side of the ASIC layer comprises a plurality of second metal pads electrically coupled to a plurality of signal interfaces of ASIC circuitry.

The method comprises iv) bonding the MEMS device platform on the cap layer. Parts of the second MEMS device layer are electrically coupled by said bonding to the respective metallic patterns arranged on the first face of the cap layer.

After said bonding the MEMS device platform on the cap layer, the method comprises, v) removing the handle layer of the MEMS device platform by etching, and optionally, prior to said etching, by grinding, to reveal the buried silicon dioxide layer that remains on top of the first MEMS device layer.

The method comprises vi) patterning the revealed buried silicon dioxide layer to form a silicon dioxide mask, vii) depositing a bond material pattern on parts of the first MEMS device layer using the silicon dioxide mask, viii) removing the silicon dioxide mask by etching, ix) placing the ASIC layer on the bond material pattern, while aligning the bond material pattern with the plurality of second metal pads. The method comprises x) bonding the ASIC layer with the first MEMS device layer to electrically couple the plurality of second metal pads to respective parts of the first MEMS device layer by said bonding.

The method comprises xi) grinding the cap layer to form a thinned cap layer, and xii) depositing first metal pads on the second face of the thinned cap layer. Each first metal pad is electrically coupled to a respective silicon via of the cap layer. The method comprises xiii) placing solder balls on at least some of the first metal pads.

Mutually electrically coupled parts of the first MEMS device layer, the second MEMS device layer, and the thinned cap layer form an ASIC signal through silicon via, AS-TSV. The AS-TSV electrically couples a second metal pad coupled to a respective signal interface of the ASIC circuitry to one of the first metal pads arranged on the second face of the thinned cap layer.

An advantage of the MEMS device of the disclosure is that the step of wire bonding between the MEMS platform and the ASIC wafer/layer/chip is avoided, which reduces manufacturing costs radically. The double-layered CSOI platform enables implementing a capacitive electrode in either one of the MEMS device layers for sensing position of a movable element in the MEMS device layers. Majority of the capacitive electrode can be mechanically separated from a substrate, which enables reducing negative effects of mechanical strain on accuracy of capacitive detection. The MEMS device structure of the disclosure removes need for separate component package and assembly of the MEMS device to the package. Manufacturing process is streamlined, since all steps can be performed in wafer level, from manufacturing to testing and/or calibrating of MEMS devices. Electrical connection paths between MEMS device layers and the ASIC layer are minimized, and electrical connection paths between the ASIC layer to underlying PCB are also kept short. Stray capacitances of electrical connections can be kept low and stable, which is particularly important for MEMS to ASIC AC connections and ground connections and between terminals. Shorter and more stable electrical connections facilitate better and stronger signals and improved error compensation, which enables reducing size of the MEMS device. MEMS device size can be reduced in comparison to MEMS device designs that use internal bonding wires.

### BRIEF DESCRIPTION OF THE DRAWINGS

In the following the disclosure will be described in greater detail by means of preferred embodiments with reference to the accompanying drawings, in which:
Figure 1 illustrates a part of a cap wafer;
Figure 2 illustrates a part of a MEMS device platform;
Figure 3 illustrates a part of an ASIC wafer;
Figure 4 illustrates a part of a cap wafer attached to a part of a MEMS device platform;
Figure 5 illustrates removal of a handle wafer from the MEMS device platform;
Figure 6 illustrates patterning a silicon dioxide layer into a silicon dioxide mask;
Figure 7 illustrates generating a bond material pattern;
Figure 8 illustrates removal of the silicon dioxide mask;
Figure 9 illustrates bonding of the ASIC wafer with the MEMS device layer;
Figure 10 illustrates final steps of manufacturing and a MEMS device according to some embodiments;
Figure 11 illustrates a MEMS device according to some embodiments.
Figure 12 illustrates a MEMS device according to some embodiments.

The figures are for illustrative purposes only and are not shown in scale.

### DETAILED DESCRIPTION OF THE DISCLOSURE

The disclosure relates to a MEMS device structure and a method to produce such MEMS device structure.

Single-crystal silicon, mono-Si, known also as monocrystalline silicon is the well-known base semiconductor material for silicon-based discrete components and integrated circuits. It consists of silicon in which the crystal lattice of the entire solid is continuous. Mono-Si is the material of first choice for robust MEMS devices, because of its excellent mechanical strength and elasticity, and the large variety of available standard processes. It is well known in the art, that in MEMS devices mono-Si layer is used as a conductor, for which purpose it is doped to make the crystal lattice electrically conducting. For example, Boron-doped P-type silicon wafers are common, but also Phosphorus (P) doped N-type wafers are used in some special applications. Disclosed manufacturing method and MEMS devices may be based on using any known electrically conducting mono-Si wafers. In context of this disclosure, a reference to silicon wafer refers to such electrically conducting, doped mono-Si wafer, unless otherwise defined.

In this context, silicon dioxide, known also as silica, is an oxide of silicon with chemical formula SiO₂. Silicon dioxide is an electrical insulator widely used in MEMS device manufacturing.

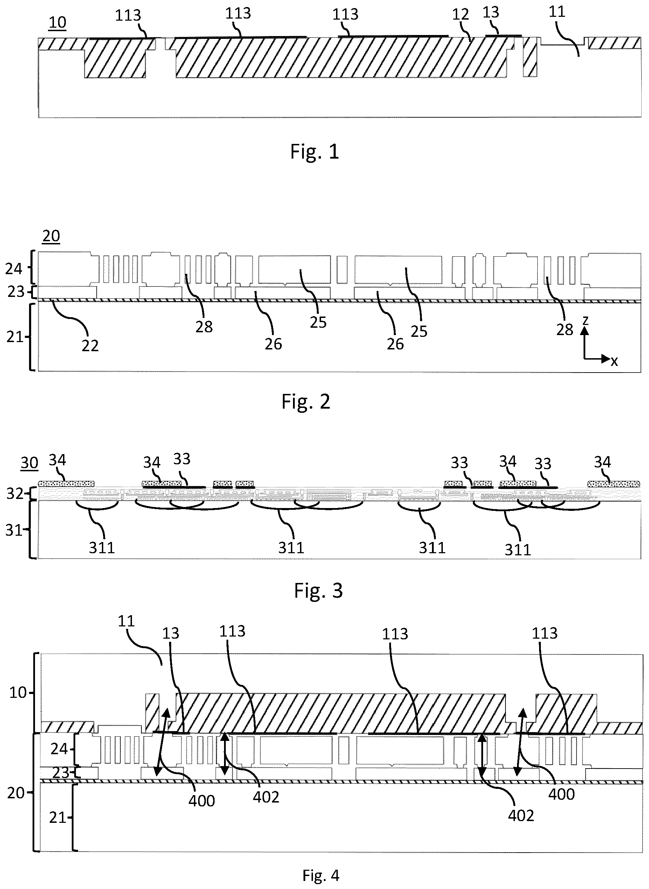

Figure 1 illustrates a cross-section of part of a cap wafer, representing a cap layer 10. In this example, the cap layer 10 is made out of a 3D-patterned silicon wafer 11. Recessed portions of the 3D-patterned silicon wafer 11 are filled with non-conducting material, which in this non-limiting example is glass 12, for example borosilicate glass, which is particularly suitable because it has essentially similar temperature behaviour as mono-Si has. The cap layer 10 further comprises metallic patterns 13, 113. These metallic patterns 13, 113 may be configured to be used as static electrodes 113 of the MEMS device and/or as first electrical contacts 13 for electrical signals.

Figure 2 illustrates a cross-section of a MEMS device platform 20 as known in the art. This type of MEMS device platform 20 is typically referred to as a double layer cavity silicon-on-insulator or double layer cavity bonded silicon-on-insulator, in short DL-CSOI, type structures. The MEMS device platform 20 comprises a handle layer 21, a buried silicon dioxide layer 22, a first MEMS device layer 23 and a second MEMS device layer 24. The first MEMS device layer 23 and the second MEMS device layer have been 3D-patterned by etching a mono-Si wafer. In this example, the first MEMS device layer 23 and the second MEMS device layer 24 are directly bonded to each other using for example anodic bonding. As known in the art, anodic bonding uses electrostatic force and electric voltage for bonding. Both MEMS device layers are made of monocrystalline silicon, manufactured using a silicon-on-insulator, SOI, process that utilizes etching, preferably dry etching such as deep reactive-ion etching (DRIE) or like, for determining various functional elements in the two MEMS device layers. Word cavity in term CSOI refers to cavities in the silicon structure.

During manufacturing of the second MEMS device layer 24, desired areas of the mono-SI layer forming the second MEMS device layer 24 have been fully removed by etching for manufacturing functional elements of the MEMS device such as movable masses 25, springs, bars, movable electrodes 28 and/or static electrodes, to mention a few. Movable masses 25 of the MEMS device are in this schematic example comprised in the second MEMS device layer 24, but other arrangements are possible. Parts of the first and/or second MEMS device layer are recessed below the original face of the mono-Si wafer from which the respective first and/or second MEMS device layer 23, 24 was patterned to have enough free space to give room for movement of moving functional elements of the second MEMS device layer 24. Any applicable etching method may be used for manufacturing the first and second MEMS device layers 23, 24. Movable masses 25 may be in the first MEMS device layer 23 and/or in the second MEMS device layer 24 depending on type and design of the MEMS device.

In this non-limited example, although not specifically shown in the drawing, at least some of the movable masses 25 may be considered to act also as movable electrodes. The exemplary first MEMS device layer 23 comprises static electrodes 26, and the movable and static electrodes may be used to capacitively detect position of the movable mass 25 in the z-axis direction. The second MEMS device layer 24 may also comprise movable and/or static electrodes. For example, one or more static electrodes may be arranged in the second MEMS device layer 24 next to a movable mass 25 to detect position of a movable mass in a lateral direction (x- or y-axis) along a lateral plane determined by the second MEMS device layer 24. Typically, x- and y-axis of the MEMS device refer to two mutually orthogonal lateral directions parallel to the plane defined by the silicon wafer that was used for manufacturing the respective MEMS device layer, while the z-axis refers to the vertical direction orthogonal to the plane determined by the x- and y-axes. Movement of a movable element in the z-axis direction may also be referred to as out-of-plane movement and z-axis direction may also be referred to as out-of-plane direction. This naming convention is based on the basic principle that a MEMS device layer is manufactured from a thin layer of silicon (either monocrystal silicon or polycrystal silicon), which layer defines a plane. Depending on type and design of the MEMS device, movable elements of the MEMS device may be designed to move linearly and/or rotationally within the plane, in x- and/or y-directions and/or linearly and/or rotationally out-of-plane, in z-axis direction.

In this non-limiting example, the first MEMS device layer 23 comprises non-movable functional elements of the MEMS device. The first MEMS device layer 23 provides mechanical support for desired static functional elements of the second MEMS device layer 24. By mutually coupling the two MEMS device layers 23, 24 by anodic bonding, selected functional elements on different MEMS device layers are provided with direct electrical contact to each other in addition to mechanical contact and support. This kind of direct coupling can be manufactured with relatively few process steps. EP 4425189 A1 illustrates an example of a capacitive MEMS device in which parts of MEMS device layers are directly coupled with each other by bonding. In some embodiments of a MEMS device with two silicon-based MEMS device layers, like the one illustrated in EP4421022 A1, there may be an insulating layer between the two MEMS device layers. In such case, vias are generated in the insulating layer and/or the MEMS device layers to provide electrical coupling where desired. Generation of separate vias tends to increase number of process steps needed to manufacture the MEMS device platform and therefore adds cost.

Figure 3 illustrates a cross-section of a part of an ASIC layer 30. The exemplary ASIC layer 30 is a CMOS ASIC, which comprises a substrate layer 31 and a metal stack 32. ASIC circuitry 311 on the face of the substrate layer 31 that is towards the metal stack 32 is manufactured by doping the substrate layer 31 as known in the art. ASIC circuitry 311 is configured to perform signal processing. The metal stack 32 comprises signal routing as well as optional passive components such as resistors and capacitors. Input and/or output signal interfaces for the signals of the ASIC circuitry 311 are provided via the metal stack 32. As known in the art the ASIC circuitry 311 may be configured to input, output and/or process analog signals received from and/or provided to MEMS electrodes, and the ASIC circuitry 311 is typically further configured to input, output and/or process digital signals. The ASIC circuitry 311 also needs operating power and ground. The outer face of the ASIC layer 30 on the side of the metal stack 32 is provided with second metal pads 33 that provide electrical connections to and from the ASIC layer 30 via the metal stack 32. In this non-limiting example, a layer of bonding material 34 has been applied on second metal pads 33. The bonding material may be metal, such as copper or aluminium, or a stack of thin layers of more than one metal, but the bonding material may alternatively be germanium or a stack of thin layers of germanium and metal. A benefit of using germanium as bonding material is that it can be patterned using similar patterning methods that are used for patterning silicon wafers and/or silicon dioxide. Although germanium as such is not conductive, it can be bonded for example with aluminium to implement eutectic bonding, which provides robust and uniform bonding two silicon wafers with direct electrical coupling between bonded parts.

Manufacturing methods for manufacturing the cap layer 10, the MEMS device platform 20 and the ASIC layer 30 are considered herein known as such and used as a starting point of the method of manufacturing a fully functional MEMS device. Steps of an exemplary manufacturing process are described with reference to figures 4 to 10. Figures 4 to 10 illustrate respective layers. As explained above, manufacturing is preferably performed in wafer form, and individual MEMS devices are preferably separated (diced) only after the manufacturing process has been completed. The manufacturing process may comprise or be followed by testing and/or calibrating MEMS devices before dicing.

Figure 4 illustrates a cross-sectional view of a cap layer 10 attached to a MEMS device platform 20. This attachment is preferably performed by using anodic bonding, which produces direct electrical connections between parts of the second MEMS device layer 24 and parts of the 3D-patterned silicon wafer 11 of the cap layer 10 that are bonded to each other. Arrows in the figure 4 illustrate two different types of direct electrical connections provided at this phase. A first direct connection 400 extends from the first MEMS device layer 23 through the second MEMS device layer 24 all the way to the 3D-patterned silicon wafer 11 of the cap layer 10. A second direct connection 402 extends from the first MEMS device layer 23 through the second MEMS device layer 24 to the metallic patterns 13, 113 of the cap layer 10. Metallic patterns 13, 113 may be designed as static electrodes 113, or they may be used as first electrical contacts 13 facilitating good coupling of signals between the second MEMS device layer 24 and the cap layer 10.

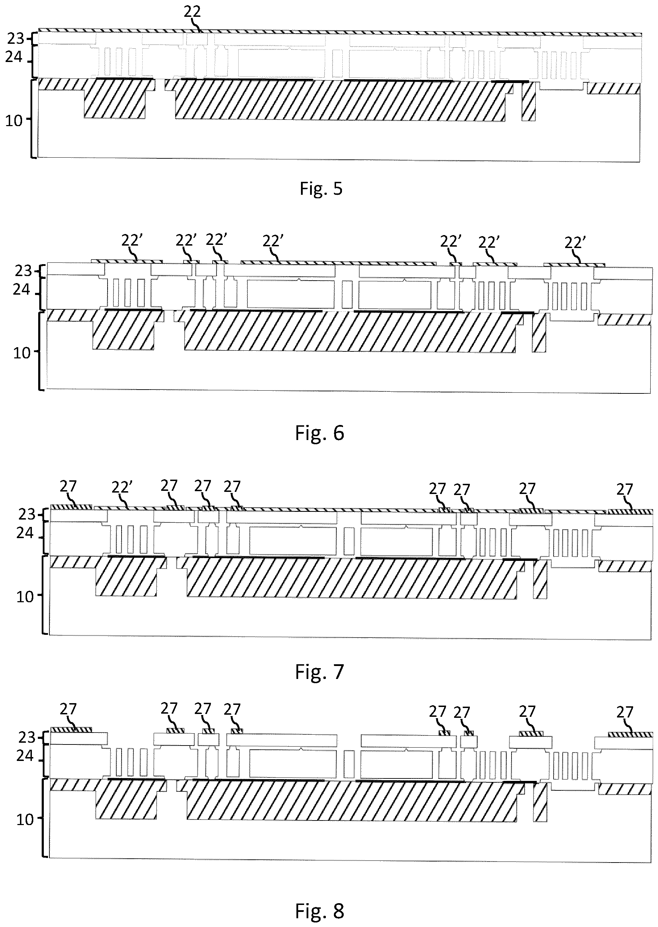

Figure 5 illustrates a cross-sectional view of removal of a handle layer 21 from the MEMS device platform 20. The entire handle layer 21 is removed preferably by grinding and/or etching so that the buried silicon dioxide layer 22 is revealed, remaining on top of the first MEMS device layer 23. The handle layer 21 may be removed for example by plasma etching or wet chemical etching. Grinding may be applied before etching to reduce thickness of the handle layer 21 before etching. Grinding beneficially speeds up the process of removal.

Figure 6 illustrates a cross-sectional view of patterning the now revealed buried silicon dioxide layer 22. The revealed buried silicon dioxide layer 22 is patterned and etched to form a silicon dioxide mask 22'. Examples of applicable etching methods for patterning the silicon dioxide layer are buffered oxide etching (BOE), also known as buffered hydrofluoric acid, BHF, etching, diluted hydrofluoric acid, HF, wet etching and oxide plasma dry etching.

Figure 7 illustrates a cross-sectional view of an example of generating a bond material pattern 27 on parts of the face of the first MEMS device layer 23. The silicon dioxide mask 22' is used for generating a bond material pattern 27. The bond material of the bond material pattern may be metal, such as aluminium or copper. For preparing to Ge-Al eutectic bonding, aluminium is used as bond material pattern 27, when the bonding material 34 on the ASIC layer is germanium. The bond material pattern 27 may be generated for example by physical vapor deposition (PVD) or by chemical vapor deposition (CVD) or by atomic layer deposition (ALD).

Figure 8 illustrates a cross-sectional view after removal of the silicon dioxide mask 22'. The silicon dioxide mask 22' is preferably removed using plasma etching, which effectively removes silicon dioxide, but does not harm mono-Si structures of the first and second MEMS device layers 23, 24. Only the bond material pattern 27 remains at desired parts on the face of the first MEMS device layer 23.

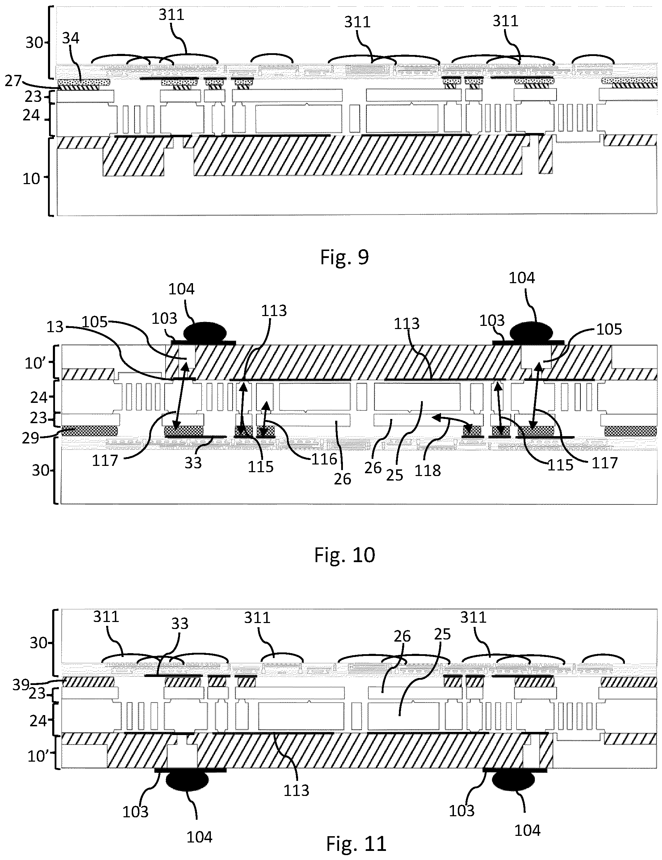

Figure 9 illustrates a cross-sectional view after placing of the ASIC layer 30 on the first MEMS device layer 23. In this non-limiting example, the ASIC layer 30 is placed on top of the first MEMS device layer 23 so that the bond material patterns 27 and the layer of bonding material 34 on second metal pads 33 are aligned and contact each other. In the example shown in the figure 9, the bond material patterns 27 are metal, i.e. aluminium, and bonding material 34 is germanium. Bonding is finalized by subjecting the device to temperatures and/or pressure in which the aluminium and the germanium form the desired eutectic bond. If only metal is used for bonding the ASIC layer 30 on the first MEMS device layer 23, bond material pattern 27 may be metal, in which case, second metal pads 33 of the ASIC layer 30 may be provided with bonding material 34 that is metal, but this is not necessary.

Figure 10 illustrates a cross-sectional view of result of final steps of the process of manufacturing the MEMS device according to some embodiments. A eutectic bond 29 is shown between parts of the ASIC layer 30 and parts of the first MEMS device layer 23. Preferably, all second metal pads 33 of the ASIC layer 30 are bonded, but bonding is also used close to the outer circumference of the MEMS device. By applying circumferential bonding pattern at or near the outer edges of the MEMS device, functional parts of the MEMS device layers 23, 24 can be protected from unwanted exposure to ambient environment. Such circumferential bonding pattern is also referred to as a guard ring.

Usually, after bonding the ASIC layer 30 on the first MEMS device layer 23, the device is flipped upside down and the cap layer 10 is thinned by grinding. The thinning step separates silicon vias 105 of the thinned cap layer 10' electrically from each other. These silicon vias 105 were originally an integral part of the original 3D-patterned silicon wafer 11. First metal pads 103 are added that are collocated with the silicon vias 105 and solder balls 104 are added on the first metal pads 103 to facilitate coupling of the MEMS device for example on a printed circuit board. Alternatively, thinning of the cap layer 10 may be performed before bonding the ASIC layer 30. Thinning of the cap layer 10 reduces mechanical stability of the cap layer. Therefore, thinning of any excess thickness of the cap layer 10 is preferably performed only after all layers of the MEMS device are mutually bonded. In some embodiments, also the substrate layer 31 of the ASIC layer 30 may be thinned at any suitable point of the manufacturing process after the ASIC layer 30 has been bonded with the second MEMS device layer 23.

The exemplary MEMS device may comprise any of several different types of through-silicon-vias (TSV) 115, 116, 117 illustrated with arrows.

ASIC signal through-silicon-vias, AS-TSVs 117, refer to through-silicon-vias for coupling signals of the ASIC circuitry to outside of the MEMS device. Each AS-TSV starts from a second metal pad 33 of the ASIC layer 30, extends via the eutectic bond 29, the first MEMS device layer 23, the second MEMS device layer 24 and via the first electrical contact 13 and the silicon vias 105 in the thinned cap layer 10' to the metal pads 103. The first metal pad 103 may be provided with a solder ball 104 to facilitate soldering of the MEMS device for example on a printed circuit board.

The MEMS device may also comprise MEMS through-silicon-vias, referred in short as MEMS-TSVs. Difference of the MEMS-TSVs and AS-TSVs is that AS-TSVs, provide electrical connections all the way to the second face of the first metal pads 103 of the thinned cap layer 10', whereas MEMS-TSVs provide internal electrical connections from the ASIC layer to electrodes in any of the MEMS device layers 23, 24 and/or metallic patterns 13 113 on the first face of the thinned cap layer 10'. The example shown in figure 10 illustrates some alternatives for MEMS-TSVs.

First MEMS-TSVs 115 are provided between metallic patterns 13, 113 on the first face of the thinned cap layer 10' and the ASIC layer 30, the first MEMS-TSVs 115 traveling through both MEMS device layers 23, 24. First MEMS-TSVs enable using metallic patterns 13, 113 on the first face of the cap layer 10' for example as static electrodes 113 that enable capacitively detecting position of a movable mass in the second MEMS device layer 24. The exemplary design shows an optional arrangement which enables differential detection of position of the movable mass 25 with two static electrodes 113, 26 placed on two mutually opposite sides of the movable mass 25. In comparison to a MEMS device with just a single MEMS device layer, the two MEMS device layer structure according to the disclosure enables implementing static electrodes 26 in the first MEMS device layer 23 rather than on the face of the ASIC layer 30. This provides mechanical benefits which may also improve signal quality.

Second MEMS-TSVs 116 may be provided between electrodes formed in the second MEMS device layer 24 and the ASIC layer 30. Depending on the design of the MEMS device, the MEMS device may comprise first MEMS-TSVs 115 and/or second MEMS-TSVs 116, but neither is mandatory, since the eutectic bond 29 may be directly electrically couple a second metal pad 33 of the ASIC layer 30 to a static electrode 26 provided in the first MEMS device layer, as illustrated by arrow 118. The second MEMS-TSV 116 is illustrated in the Figure 10 by the arrow. It is noted that for implementing an electrode in the second MEMS device layer 24, there is preferably no electrical connection to a static electrode 26 in the first device layer, although such connection appears in the

Figure 10. As for design and layout of the MEMS device, it is desirable to place AS-TSVs 117 away from each other and closer to the outer edges of the MEMS device than the first and second MEMS-TSVs 115, 116. This facilitates mechanical stability of the MEMS device when assembled. Also, physical distance between AS-TSVs and MEMS-TSVs help avoiding unwanted effects of digital signals to and/or from the ASIC on MEMS signals. AS-TSVs may also be noise protected by designing the AS-TSVs as coaxially shielded vias, where the AS-TSV extends inside a grounded coaxial shielding separated from the signal path of the AS-TSV by air or other gas used for filling the cavity, or by dielectric material, such as silicon dioxide.

Figure 11 illustrates a cross-sectional view of a MEMS device according to an alternative embodiment in which bonding between the ASIC layer 30 on the first MEMS device layer 23 is implemented using metal bonding, i.e. that bonding material 39 is metal, such as aluminium or copper. Majority of manufacturing steps of the MEMS device according to this embodiment are similar to those described above, with the exception that no germanium and germanium-aluminium eclectic bonding is applied but selected bonding material 39 is added on the ASIC layer 30 and/or the first MEMS device layer 23.

Selection of type of applied type of bonding between the ASIC layer 30 and the first MEMS device layer 23 is a design option, which is independent of other design features of the MEMS device illustrated herein. The main requirement for the type of bonding used between the ASIC layer 30 and the first MEMS device layer 23 is that it enables electric connectivity between desired parts of the first MEMS device layer 23 and the ASIC layer 30. Furthermore, when the ASIC layer 30 is based on CMOS technology, the bonding method shall be compatible with the CMOS technology, which sets some limits for example to applicable maximum temperature that can be used in the process of bonding. Therefore, bonding between the ASIC layer 30 and the first MEMS device layer 23 may be implemented using any known CMOS-compatible low temperature wafer bonding method. The applied bonding method may be selected among glass frit bonding, adhesive bonding, anodic bonding, eutectic metal bonding, metal to metal bonding and direct bonding, whereas the CMOS-compatibility of the selected method primarily depends on applied temperatures. In this context, low bonding temperature refers to bonding temperatures below 500°C. For example, the exemplary Al-Ge bonding is typically implemented using a bonding temperature that is slightly above 400°C. Thus, a bonding temperature between 400°C and 500°C can is considered low. Other applicable low temperature bonding methods are known in the art which may apply bonding temperatures below 200°C, depending on the alloy. Bonding methods which add a layer of material between the two layer simplify design of the first MEMS device layer 23. This is because the bond material layer increases distance between the adjacent faces of the ASIC layer 30 and the first MEMS device layer 23, thus providing room for movement of any movable elements in the first MEMS device layer 23 towards the ASIC layer 30.

Table 1 below illustrates examples of known eutectic alloys used in MEMS bonding as well as eutectic temperatures thereof. For example, eutectic temperature for Al-Ge alloy discussed in the examples typically varies between 419 and 423 depending on composition. The actual temperature used for bonding may slightly exceed the exact eutectic temperature determined by the allow. Thus, the temperature used for Al-Ge eutectic bonding may be up to 440 ° C.

**Table 1: Exemplary eutectic alloys commonly used in MEMS wafer-level packaging**

| **Eutectic alloy** | **Eutectic composition** | **Eutectic temperature** |
|---|---|---|
| **Al-Ge** | 49/51 wt% | 419°C |
| **Au-Ge** | 28/72 wt% | 361°C |
| **Au-In** | 0.6/99.4 wt% | 156°C |
| **Au-Si** | 97.1/2.9 wt% | 363°C |
| **Au-Sn** | 80/20 wt% | 280°C |
| **Cu-Sn** | 5/95 wt% | 231°C |

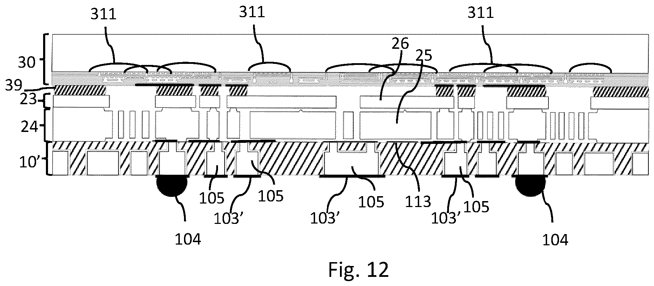

Figure 12 illustrates a cross-sectional view of a MEMS device according to some embodiments with another type of TSV provided between the ASIC layer 30 or either of the MEMS device layers 23, 24, through silicon vias 105 in the cap layer 10' and to a metal pad 103' on the cap layer 10'. This additional TSV, which may be referred to as a test-TSV, enables coupling any signal to/from the respective ASIC or MEMS device layer directly to the first metal pad 103' on the outer face of the thinned cap layer 10' for testing and/or calibration purposes, for example. First metal pads 103' that are only used for testing and/or calibration purposes may without solder balls 104. The first metal pad 103' without a solder ball 104 can be contacted with a probe of testing and/or calibration equipment without the solder ball 104. Any first metal pad 103' without a solder ball is not intended to be coupled to a PCB when the MEMS device is assembled for use.

Although associated figures illustrate a portion of layers representing elements of a single illustrative MEMS device, manufacturing of MEMS devices according to embodiments is typically performed in wafer form. The examples are not intended to show a fully functional MEMS device but illustrate main novel features of a MEMS device according to the disclosure.

Highest cost-saving benefits are achieved in the manufacturing process when the described manufacturing method is performed before separating individual MEMS platforms and ASICs from respective wafers. The cap layer 10, MEMS device layers 23, 24 and the ASIC layer 30 are all manufactured in wafer form, each wafer comprising respective functional and structural elements of respective layers of a plurality of MEMS devices, typically hundreds of MEMS devices. Wafers are stacked as illustrated above, and the plurality of MEMS devices are preferably not only manufactured, but also tested and calibrated in wafer form before the wafer stack is diced along dicing streets arranged between individual MEMS devices to separate them from each other.

To facilitate wafer-level handling, the MEMS platform wafer, the ASIC wafer and the cap wafer should be at least approximately of the same size.

According to some embodiments, the first face of the ASIC layer 30 comprises a metal pattern at or near the outer circumference of each area corresponding to a single MEMS device. This metal pattern on the first face of the ASIC layer 30 may be used for creating during the bonding process a seal ring that enables hermetic closing of the enclosure in which the functional elements of the MEMS device layers are. Typically, the seal ring is grounded, in other words it is in ground potential. A seal ring can also be implemented by means of the bonding material layer only, without separate seal ring metal pattern on the first face of the ASIC layer 30. In figures, metal pattern for seal ring is not illustrated.

The metal pattern for creating the seal ring may be manufactured on the first face of the ASIC layer simultaneously with manufacturing second metal pads 33 for enabling electrical contacts between the first face or the ASIC layer and MEMS device layers. There may be tens of such second metal pads 33 at the first face of the ASIC layer 30 in each MEMS device, and each second metal pad 33 provides a predetermined electrical connection, i.e. connected to a signal, ground or operating power.

The seal ring may be implemented by means of aluminium-germanium bonding, in which case aluminium is preferably applied on the face of the ASIC layer and a corresponding pattern of germanium is applied on the MEMS device layer.

According to some embodiments, instead of pure aluminium, the metal pattern patterned on the first face of the ASIC layer 30 may comprise stacked metal layers comprising more than one alternating layer of aluminium and titan. This facilitates reliable hermetic sealing of the enclosure by the seal ring. For example, the metal pattern may be a 1500 nm Al/Ti/Al/Ti stack with respective layer thicknesses 20nm/700nm/60nm/700nm. The corresponding germanium pattern on the second face of the second MEMS device layer 24 may also comprise a combination of titan and germanium, for example Ti 20 nm/Ge 500 nm. Bonding these layers together forms the seal ring that ensures hermetic sealing of the enclosure. The same stacked metal layers may also be used in second metal pads 33 for generating reliable electrical contacts between the second MEMS device layer and the ASIC layer. Alternatively, electrical contacts via the second metal pads 33 may be implemented as pressure contacts. An exemplary pressure contact can be implemented without any germanium at the second face of the second MEMS device layer 24, since the Al/Ti/Al/Ti stack patterned on the first face of the ASIC layer 30 can form direct electrical contacts to the doped silicon of the MEMS device layer.

## Claims

1. A microelectromechanical system, MEMS, device comprising, in the given order:
- a cap layer (10') comprising metallic patterns (13, 113) on a first face of the cap layer, first metal pads (103) on a second face of the cap layer, and silicon vias (105) electrically coupling at least part of the metallic patterns (13) and the first metal pads (103),
- a second MEMS device layer (24) comprising functional elements of the MEMS device, wherein parts of the second MEMS device layer are electrically coupled to the respective metallic patterns (13, 113) on the first face of the cap layer (10'),
- a first MEMS device layer (23) comprising further functional elements of the MEMS device, wherein parts of the first MEMS device layer (23) are electrically coupled to respective parts of the second MEMS device layer (24),
- an ASIC layer (30) comprising a metal stack (32), the outer face of the metal stack (32) forming a first face of the ASIC layer (30), and a substrate layer (31), the outer face of the substrate layer (31) forming a second face of the ASIC layer, wherein the substrate layer (31) comprises ASIC circuitry (311), wherein the first face of the ASIC layer comprises a plurality of second metal pads (33) electrically coupled via the metal stack (32) to a plurality of signal interfaces of ASIC circuitry (311), and wherein the plurality of second metal pads (33) is electrically coupled to parts of the first MEMS device layer (23),
**characterized in that** mutually electrically coupled parts of the first MEMS device layer (23), the second MEMS device layer (24), and the cap layer (10') form at least one ASIC signal through-silicon-via (117), AS-TSV, and wherein each AS-TSV (117) is configured to electrically couple a signal of the ASIC circuitry (311) via electrical contacts provided by one of the second metal pads (33) on the first face of the ASIC layer (30) to the respective first metal pad (103) on the second face of the cap layer (10').

2. The MEMS device according to claim 1, wherein the second MEMS device layer (24) comprises at least one first electrode, and wherein mutually electrically coupled parts of the first MEMS device layer (23) and the second MEMS device layer (24) form a first MEMS through silicon via (115), MEMS-TSV, that electrically couples a respective one of the at least one first electrode to a respective second metal pad (33) coupled to a respective signal interface of the ASIC circuitry (311).

3. The MEMS device according to claim 1 or 2, wherein the metallic patterns (13, 113) on a first face of the cap layer (10') further comprise at least one static electrode (113), wherein mutually electrically coupled parts of the first MEMS device layer (23) and the second MEMS device layer (24) form a second MEMS through silicon via, MEMS-TSV (116), that electrically couples a respective one of the at least one static electrode (113) to a respective second metal pad (33) coupled to a respective signal interface of the ASIC circuitry (311).

4. The MEMS device according to any one of claims 1 to 3, wherein parts of the first MEMS device layer (23) are directly electrically coupled with the second MEMS device layer (24) by means of direct bonding.

5. The MEMS device according to any one of claims 1 to 4, wherein the cap layer (10') is electrically coupled with the second MEMS device layer (24) by means of anodic bonding.

6. The MEMS device according to any one of claims 1 to 5, wherein the plurality of second metal pads (33) of the ASIC layer (30) is electrically coupled to parts of the first MEMS device layer (23) by means of any one of glass frit bonding, adhesive bonding, anodic bonding, eutectic metal bonding, metal to metal bonding and direct bonding.

7. The MEMS device according to any one of claims 1 to 6, further comprising a test-through-silicon-via, test-TSV, configured to couple a signal to or from any one of the ASIC circuitry, the first MEMS device layer, the second MEMS device layer to a first metal pad (103') for enabling testing and/or calibration of the MEMS device.

8. The MEMS device according to any one of claims 1 to 7, wherein the MEMS device is an accelerometer, a gyroscope or a combination thereof.

9. A method for manufacturing a microelectromechanical system, MEMS, device, comprising:
- providing a cap layer (10) comprising metallic patterns (13, 113) arranged on a first face of the cap layer (10),
- providing a MEMS device platform (20) comprising handle layer (21), a buried silicon dioxide layer (22), a first MEMS device layer (23) and a second MEMS device layer (24), wherein the buried silicon dioxide layer (22) is between the handle layer (21) and the first MEMS device layer (23), wherein the first MEMS device layer (23) and the second MEMS device layer (24) comprise functional elements of the MEMS device platform (20), and parts of the first MEMS device layer (23) are electrically coupled to respective parts of the second MEMS device layer (24),
- providing an ASIC layer (30) comprising substrate layer (31) comprising ASIC circuitry (311) and a metal stack (32), wherein a first face of the ASIC layer (30) on the metal stack side of the ASIC layer (30) comprises a plurality of second metal pads (33) electrically coupled to a plurality of signal interfaces of ASIC circuitry (311),
- bonding the MEMS device platform (20) on the cap layer (10), wherein parts of the second MEMS device layer (24) are electrically coupled by said bonding to the respective metallic patterns (13) arranged on the first face of the cap layer (10),
- after said bonding the MEMS device platform on the cap layer (10), removing the handle layer (21) of the MEMS device platform (20) by etching, and optionally, prior to said etching, by grinding, to reveal the buried silicon dioxide layer (22) that remains on top of the first MEMS device layer (23),
- patterning the revealed buried silicon dioxide layer (22) to form a silicon dioxide mask (22'),
- depositing a bond material pattern (27) on parts of the first MEMS device layer (23) using the silicon dioxide mask (22'),
- removing the silicon dioxide mask (22') by etching,
- placing the ASIC layer (30) on the bond material pattern (27), while aligning the bond material pattern (27) with the plurality of second metal pads (33),
- bonding the ASIC layer (30) with the first MEMS device layer (23) to electrically couple the plurality of second metal pads (33) to respective parts of the first MEMS device layer (23) by said bonding,
- grinding the cap layer (10) to form a thinned cap layer (10'),
- depositing first metal pads (103) on the second face of the thinned cap layer (10'), wherein each first metal pad (103) is electrically coupled to a respective silicon via (105) of the cap layer (10'), and
- placing solder balls (104) on at least some of the first metal pads (103),
**characterized in that** mutually electrically coupled parts of the first MEMS device layer (23), the second MEMS device layer (24), and the thinned cap layer (10') form an ASIC signal through silicon via, AS-TSV (117), that electrically couples a second metal pad (33) coupled to a respective signal interface of the ASIC circuitry (311) to the one of the first metal pads (103) arranged on the second face of the thinned cap layer (10').
